# EUROPEAN PATENT APPLICATION

(11) **EP 3 666 924 A1**
(43) Date of publication of application: **17.06.2020**
(21) Application number: 19159784.8
(22) Date of filing: 27.02.2019
(51) Int. Cl.: C23C 14/56

(54) **A DOUBLE-SIDED VACUUM COATING DEVICE FOR CONTINUOUSLY COATING A FILM BACK AND FORTH**

(30) Priority: 12.12.2018 CN 201811519640
(71) Applicant: Anhui JIMAT New Material Technology Co., Ltd., Huainan City, Anhui (CN)
(72) Inventor: YAN, Zuoyi, Anhui Province (CN); LIU, Wenqing, Anhui Province (CN)
(74) Representative: Roberts, Peter David

(57) **Abstract**

A double-sided vacuum coating device for continuously coating a film back and forth is provided, including a vacuum chamber provided with an upper winding and unwinding mechanism, an upper delivery mechanism, a lower delivery mechanism and a lower winding and unwinding mechanism therein, wherein the vacuum coating device is configured that a film to be coated can start from the upper winding and unwinding mechanism and pass through the upper delivery mechanism and the lower delivery mechanism to the lower winding and unwinding mechanism, or start from the lower winding and unwinding mechanism and pass through the lower delivery mechanism and the upper delivery mechanism to the upper winding and unwinding mechanism, and wherein each of the upper delivery mechanism and the lower delivery mechanism is provided with a coating assembly at a position corresponding to the film.

## Description

### TECHNICAL FIELD

The present invention relates to the field of coating devices, especially to a double-sided vacuum coating device for continuously coating a film back and forth.

### BACKGROUND

A particular device is necessary for coating an extremely thin film with a relatively thicker metallic conductive layer to meet requirements for flexible electric conduction and shielding material. The so-called "extremely thin film" has a thickness of 2-12µm, and is made of PP, PE, PET, PI membrane, polyester cloth, paper, or the like. The so-called "relatively thicker metallic conductive layer" has a thickness of 200-2000nm, and is made of conductive and shielding materials such as nickel, aluminum, copper, lead, silver, gold, alloy materials, etc. The biggest problem for obtaining a metallic conductive layer with a corresponding thickness on a surface of the thin film is deposition efficiency. Generally, the metal on the thin film after a single deposition has a thickness of about 5-100nm. Multiple depositions are necessary if a metallic conductive layer with a thickness of 200-2000nm is required. Typically, deposition of the conductive layer on the thin film is preceded in vacuum. When a vacuum coating device without ability to coat the film back and forth is used, it's necessary to open the cabin of the device for winding and unwinding the thin film to be deposited each time a metal layer is deposited. In this way, the cabin of the device is required to be filled with air and then evacuated each time, which decrease the operation efficiency of the device. The efficiency would be greatly improved if the device is capable of continuously coating a film back and forth.

### SUMMARY

One objective of the present invention is to provide a double-sided vacuum coating device for continuously coating a film back and forth to solve the technical problem that the vacuum coating device in the prior art is not able to continuously coat the film back and forth and thus has a low working efficiency.

The present invention is realized by the following technical solutions.

A double-sided vacuum coating device for continuously coating a film back and forth is provided, which includes a vacuum chamber provided with an upper winding and unwinding mechanism, an upper delivery mechanism, a lower delivery mechanism and a lower winding and unwinding mechanism therein, wherein the lower winding and unwinding mechanism and the lower delivery mechanism are respectively located below the upper winding and unwinding mechanism and the upper delivery mechanism, wherein the vacuum coating device is configured that a film to be coated can start from the upper winding and unwinding mechanism and pass through the upper delivery mechanism and the lower delivery mechanism to the lower winding and unwinding mechanism, or start from the lower winding and unwinding mechanism and pass through the lower delivery mechanism and the upper delivery mechanism to the upper winding and unwinding mechanism, and wherein each of the upper delivery mechanism and the lower delivery mechanism is provided with a coating assembly at a position corresponding to the film.

The present invention is further characterized as follows.

Each of the upper delivery mechanism and the lower delivery mechanism includes a pulley assembly, wherein each pulley assembly includes a driving pulley, a belt and two ratchet transmission members respectively located on both sides of the driving pulley, and the driving pulley is coupled with the two ratchet transmission members via the respective belt.

Each ratchet transmission member includes a ratchet wheel, a plurality of pawls and a plurality of compression springs, wherein each of the plurality of pawls has a free end which is engaged with teeth of the ratchet wheel on one side and connected with the respective one of the compression springs on the other side.

Each pulley assembly further includes a cooling drum and two smoothing rollers, wherein the cooling drum is coaxially connected with the driving pulley, and each smoothing roller is coaxially connected with the respective one of the ratchet wheels.

The vacuum coating device further includes at least a pair of transitional rollers provided between the upper delivery mechanism and the lower delivery mechanism.

The vacuum coating device further includes a plasma-source cleaning unit provided beside the film to be coated for cleaning the film.

The coating assembly is selected from one of a group consisting of a resistance vaporizing apparatus, an intermediate frequency induction vaporizing crucible apparatus, a magnetron sputtering apparatus and an electron gun apparatus.

The present invention has the following advantages:
The double-sided vacuum coating device for continuously coating a film back and forth according to the present invention is provided with the upper and the lower winding and unwinding mechanisms and the upper and the lower coating assembly, such that double-sided continuous coating of a film back and forth in vacuum is achieved and the working efficiency of the vacuum coating device is greatly improved compared with the prior art.

### BRIEF DESCRIPTION OF THE DRAWINGS

FIG. 1 shows a structural schematic view of a double-sided vacuum coating device for continuously coating a film back and forth according to the present invention;
FIG. 2 shows a structural schematic view of a pulley assembly in the double-sided vacuum coating device for continuously coating a film back and forth according to the present invention;
FIG. 3 shows a structural schematic view of another pulley assembly in the double-sided vacuum coating device for continuously coating a film back and forth according to the present invention;
FIG. 4A and 4B show a structural schematic view of ratchet transmission members in the double-sided vacuum coating device for continuously coating a film back and forth according to the present invention;
FIG. 5A and 5B show a structural schematic view of further ratchet transmission members in the double-sided vacuum coating device for continuously coating a film back and forth according to the present invention.

### DESCRIPTION OF THE EMBODIMENTS

In order to make the objective, the technical solution and the advantages of the present invention more apparent, the present invention will be further described below with reference to the accompanying drawings. It should be appreciated that specific embodiments described hereinafter are merely illustrative and are not intended to limit the present invention.

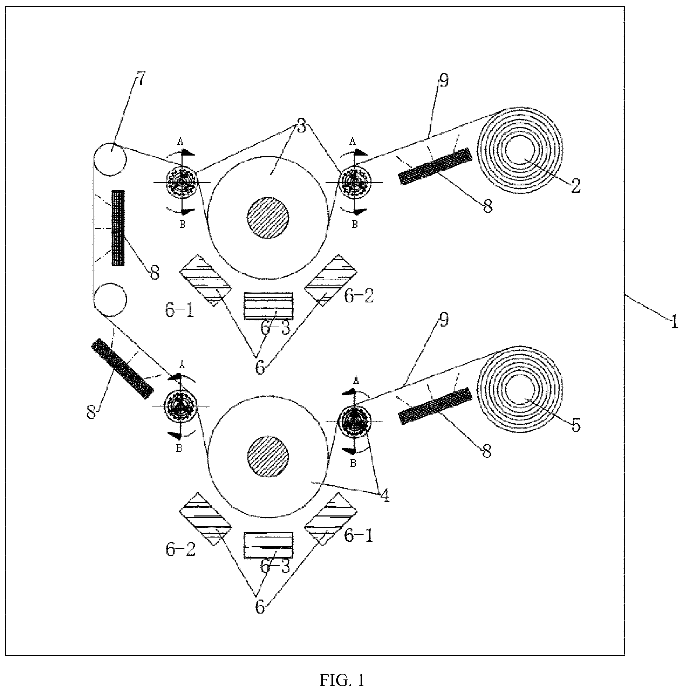

A double-sided vacuum coating device for continuously coating a film back and forth according to the present invention is shown in Figure 1. The vacuum coating device includes a vacuum chamber 1 provided with an upper winding and unwinding mechanism 2, an upper delivery mechanism 3, a lower delivery mechanism 4 and a lower winding and unwinding mechanism 5 therein. The lower winding and unwinding mechanism 5 and the lower delivery mechanism 4 are respectively located below the upper winding and unwinding mechanism 2 and the upper delivery mechanism 3. The vacuum coating device is configured that a film to be coated can start from the upper winding and unwinding mechanism 2 and pass through the upper delivery mechanism 3 and the lower delivery mechanism 4 to the lower winding and unwinding mechanism 5, or start from the lower winding and unwinding mechanism 5 and pass through the lower delivery mechanism 4 and the upper delivery mechanism 3 to the upper winding and unwinding mechanism 2. Each of the upper delivery mechanism 3 and the lower delivery mechanism 4 is provided with a coating assembly 6 at a position corresponding to the film.

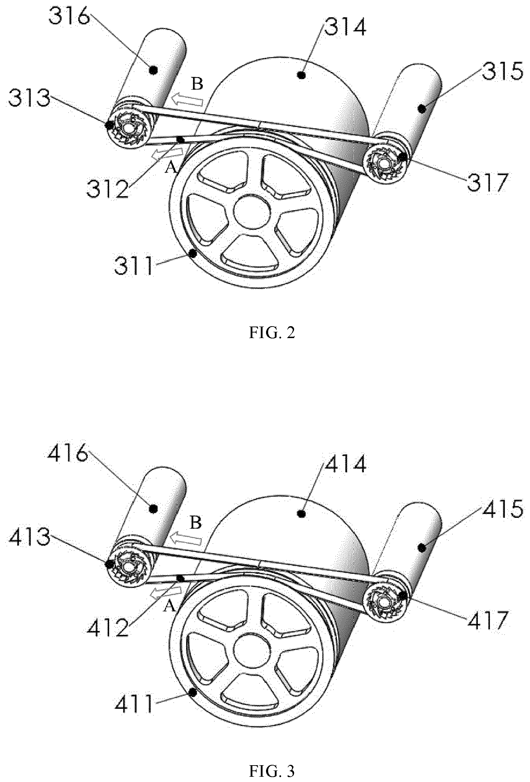

As shown in Figures 2 and 3, each of the upper delivery mechanism 3 and the lower delivery mechanism 4 includes a pulley assembly 31, 41. Each pulley assembly 31, 41 includes a driving pulley 311, 411, a belt 312, 412 and two ratchet transmission members 313, 317, 413, 417 respectively located on both sides of the driving pulley 311, 411. The driving pulley 311, 411 is coupled with the two ratchet transmission members 313, 317, 413, 417 via the respective belt 312, 412.

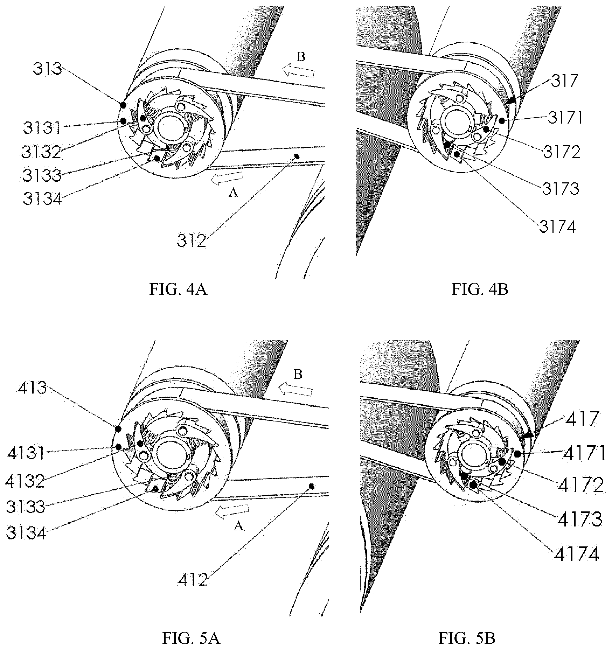

As shown in Figures 4 and 5, each ratchet transmission member 313, 317, 413, 417 includes a ratchet wheel 3131, 3171, 4131, 4171, a plurality of pawls 3132, 3172, 4132, 4172 and a plurality of compression springs 3133, 3173, 4133, 4173. Each of the plurality of pawls 3132, 3172, 4132, 4172 has a free end which is engaged with teeth 3134, 3174, 4134, 4174 of the ratchet wheel 3131, 3171, 4131, 4171 on one side and connected with the respective one of the compression springs 3133, 3173, 4133, 4173 on the other side.

Each pulley assembly 31, 41 further includes a cooling drum 314, 414 and smoothing rollers 315, 415, 316, 416. The cooling drum 314, 414 is coaxially connected with the driving pulley 311, 411 via a key and is driven together with the driving pulley 311, 411 by an external motor. Preferably, two smoothing rollers are provided. Each smoothing roller is coaxially connected with and rotated together with the respective one of the ratchet wheels 3131, 4131 via a flat key.

As shown in Figure 2 to Figure 5B, the ratchet transmission member 313, 413 is in a driving state in the rotational direction where the ratchet wheel 3131, 4131 is driven by the belt 312, 412 to rotate in a direction B and meanwhile the pawls 3132, 4132 are pushed out by the compression springs 3133, 4133 to bear against the teeth 3134, 4134. Conversely, the ratchet transmission member 313, 413 is in a driven state in the rotational direction where the ratchet wheel 3131, 4131 is driven by the belt 312, 412 to rotate towards a direction A and meanwhile the free ends of the pawls 3132, 4132 are moved over the periphery of the teeth 3134, 4134 instead of bearing against the teeth 3134, 4134 even though they are pushed out by the compression springs 3133, 4133.

The vacuum coating device further includes at least a pair of transitional rollers 7 provided between the upper delivery mechanism 3 and the lower delivery mechanism 4. The vacuum coating device further includes a plasma-source cleaning unit 8 provided beside the film to be coated for cleaning the film. The coating assembly 6 is selected from one of a group consisting of a resistance vaporizing apparatus, an intermediate frequency induction vaporizing crucible apparatus, a magnetron sputtering apparatus and an electron gun apparatus.

The double-sided vacuum coating device for continuously coating a film back and forth according to the present invention includes the upper winding and unwinding mechanism 2 and the lower winding and unwinding mechanism 5, each of which is provided with a coating assembly 6, such that double-sided continuous coating of a film back and forth in vacuum can be achieved by winding of the film begins from either the upper winding and unwinding mechanism 2 or the lower winding and unwinding mechanism 5. Taking the film starting being wound from the upper winding and unwinding mechanism 2 as an example, as shown in Figures 1-3, the upper winding and unwinding mechanism 2 works as a feed-out apparatus, and the film starts from the upper winding and unwinding mechanism 2 and passes through the smoothing roller 315, the cooling drum 314, the smoothing roller 316, the transitional rollers 7, the smoothing roller 416, the cooling drum 414 and the smoothing roller 415 in sequence to the lower winding and unwinding mechanism 5. When the film arrives at the cooling drum 314 driven by the driving pulley 311 after passing through the smoothing roller 315, one side of the film is firstly coated with a metallic conductive layer by the upper coating assembly 6. The film then arrives at the cooling drum 414 driven by the lower driving pulley 411 after passing through the smoothing roller 316, the transitional rollers 7 and the smoothing roller 416, by this time the other side of the film is coated with a metallic conductive layer by the lower coating assembly 6. Afterwards, the film passes through the smoothing roller 415 and arrives at the lower winding and unwinding mechanism 5. In this way, both sides of the film are coated with metallic conductive layers by a single coating process. The film is required to be in a tension state for conforming to the surface of the cooling drum as tightly as possible during the coating process. The smoothing roller after an outlet of the cooling drum should be active in motion, while the smoothing roller prior to an inlet of the cooling drum should be passive in motion. In this way, when in a forward direction, the film has its front provided with a driving force and has its rear without a driving force, such that the film is in a tension state to ensure that the film tightly lies against the surface of the cooling drum. Taking the film being unwound in the upside and wound in the downside, the film starts from the upper winding and unwinding mechanism 2 and passes through the smoothing roller 315, the cooling drum 314, the smoothing roller 316, the transitional rollers 7, the smoothing roller 416, the cooling drum 414 and the smoothing roller 415 in sequence to the lower winding and unwinding mechanism 5. For the upper cooling drum 314, in order to ensure that the film tightly lies against the surface of the cooling drum 314, the ratchet wheel and the pawls in the smoothing roller 316 are in the driving state to drive the smoothing roller 316 to rotate, and meanwhile the smoothing roller 315 is pulled by the film to rotate as the ratchet wheel and the pawls in the smoothing roller 315 are in the driven state. In this way, the film is in the tension state in a movement direction. When the film is unwound in the downside and is wound in the upside, the film starts from the lower winding and unwinding mechanism 5 and passes through the smoothing roller 415, the cooling drum 414, the smoothing roller 416, the transitional rollers 7, the smoothing roller 316, the cooling drum 314 and the smoothing roller 315 in sequence to the upper winding and unwinding mechanism 2. For the upper cooling drum 314, in order to ensure that the film tightly lies against the surface of the cooling drum 314, the ratchet wheel and the pawls in the smoothing roller 315 are in the driving state to drive the smoothing roller 315 to rotate, and meanwhile the smoothing roller 316 is pulled by the film to rotate as the ratchet wheel and the pawls in the smoothing roller 316 are in the driven state. In this way, the film is in the tension state in a movement direction. By means of this configuration, the film is in the tension state to conform to the surface of the cooling drum regardless of the movement direction, such that double-sided continuous coating of a film back and forth can be achieved.

### Embodiment 1:

In the case that the upper winding and unwinding mechanism 2 unwinds the film with an unwinding diameter of 600mm, and the base material of the film is PI membrane. The coating assembly 6 includes an intermediate frequency induction heating crucible 6-3 and at least two magnetron sputtering targets 6-1, 6-2 in the form of plane targets with the target material being nickel. The crucible has pure copper particles with purity of ≥99.95% placed therein. The purity of the target material is ≥99.99%. The film starts from the upper winding and unwinding mechanism 2 and passes through the smoothing roller 315, the cooling drum 314, the smoothing roller 316, the transitional rollers 7, the smoothing roller 416, the cooling drum 414 and the smoothing roller 415 in sequence to the lower winding and unwinding mechanism 5. The cooling drum 314, 414 utilize coolant circulation to perform cooling, with a cooling temperature of -25 °C, and coating of the film is applied in vacuum with pressure of ≤ 8 × 10-1Pa. During the first passing process of the film, the magnetron sputtering target 6-2 and the crucible 6-3 are turned on, and the film moves in a speed of 10-60m/min. Both sides of the film are coated with a nickel layer with a thickness of 5-30nm as a base layer and a copper layer with a thickness of 50-300nm on the nickel layer. After the first passing process, the second to the sixth passing processes are proceeded without necessary to take the film out of the chamber. During the second to the sixth passing processes, only the crucible 6-3 is turned on, and the film moves in a speed of 10-60m/min. The coated copper layers on both sides of the film are each has its thickness increased by 250-1500nm after 5-times passing processes. After the sixth passing process, the seventh passing process is preceded without necessary to take the film out of the chamber. During the seventh pass, the magnetron sputtering target 6-1 and the crucible 6-3 are turned on, and the film moves in a speed of 10-60m/min. The coated copper layers on both sides of the film are each has its thickness further increased by 50-300nm, and a nickel layer with a thickness of 5-30nm is further coated on the copper layer. After 7-times passing processes, a base nickel layer with a thickness of 5-30nm, an intermediate copper layer with a thickness of 350-2100nm, and a surface nickel layer with a thickness of 5-30nm are coated on each side of the film. The film can be completely coated after entering into the chamber without getting out of the chamber according to the present invention. Compared with the prior art which requires entering into and getting out of the chamber repeatedly for 7 times, the working efficiency of the vacuum coating device according to the present invention is greatly improved by 85.71%, and the usage ratio of the raw materials is improved by 8%. Impurities and oxidation on the surface of the film are effectively reduced as there is no need to wind and unwind the film after each passing process.

Devices, mechanisms, components, and operating methods that are commonly used in the art and have the same functions as the devices, mechanisms, components, and operating methods that are not described in detail herein may be employed by those skilled in the art to implement the present invention.

Described above are only preferred embodiments of the present invention, and any equivalent changes and modification made within the scope of the claims of the present invention shall be covered by the scope of the claims of the present invention.

## Claims

1. A double-sided vacuum coating device for continuously coating a film back and forth, **characterized in that**, the device comprises a vacuum chamber provided with an upper winding and unwinding mechanism, an upper delivery mechanism, a lower delivery mechanism and a lower winding and unwinding mechanism therein, wherein the lower winding and unwinding mechanism and the lower delivery mechanism are respectively located below the upper winding and unwinding mechanism and the upper delivery mechanism, wherein the vacuum coating device is configured that a film to be coated can start from the upper winding and unwinding mechanism and pass through the upper delivery mechanism and the lower delivery mechanism to the lower winding and unwinding mechanism, or start from the lower winding and unwinding mechanism and pass through the lower delivery mechanism and the upper delivery mechanism to the upper winding and unwinding mechanism, and wherein each of the upper delivery mechanism and the lower delivery mechanism is provided with a coating assembly at a position corresponding to the film.

2. The vacuum coating device according to claim 1, **characterized in that**, each of the upper delivery mechanism and the lower delivery mechanism comprises a pulley assembly, wherein each pulley assembly comprises a driving pulley, a belt and two ratchet transmission members respectively located on both sides of the driving pulley, and the driving pulley is coupled with the two ratchet transmission members via the respective belt.

3. The vacuum coating device according to claim 2, **characterized in that**, each ratchet transmission member comprises a ratchet wheel, a plurality of pawls and a plurality of compression springs, wherein each of the plurality of pawls has a free end which is engaged with teeth of the ratchet wheel on one side and connected with the respective one of the compression springs on the other side.

4. The vacuum coating device according to claim 3, **characterized in that**, each pulley assembly further comprises a cooling drum and two smoothing rollers, wherein the cooling drum is coaxially connected with the driving pulley, and each smoothing roller is coaxially connected with the respective one of the ratchet wheels.

5. The vacuum coating device according to any one of claims 1-4, **characterized in that**, the vacuum coating device further comprises at least a pair of transitional rollers provided between the upper delivery mechanism and the lower delivery mechanism.

6. The vacuum coating device according to claim 5, **characterized in that**, the vacuum coating device further comprises a plasma-source cleaning unit provided beside the film to be coated for cleaning the film.

7. The vacuum coating device according to any one of claims 1-4, **characterized in that**, the coating assembly is selected from one of a group consisting of a resistance vaporizing apparatus, an intermediate frequency induction vaporizing crucible apparatus, a magnetron sputtering apparatus and an electron gun apparatus.
